# EUROPÄISCHE PATENTANMELDUNG

(11) **EP 1 113 448 A1**
(43) Veröffentlichungstag der Anmeldung: **04.07.2001**
(21) Anmeldenummer: 00126108.0
(22) Anmeldetag: 29.11.2000
(51) Int. Cl.: G11C 7/10, G11C 7/06, G11C 11/408, G11C 11/409

(54) **Schaltungsanordung für einen intergrierten Halbleiterspeicher mit Spaltenzugriff**

(30) Priorität: 28.12.1999 DE 19963502
(71) Anmelder: Infineon Technologies AG, 81669 München (DE)
(72) Erfinder: Schneider, Helmut, 80993 München (DE); Schoeniger, Sabine, 83714 München (DE)
(74) Vertreter: Fischer, Volker, Dipl.-Ing.

(57) **Zusammenfassung**

Eine Schaltungsanordnung für einen integrierten Halbleiterspeichers weist Speicherzellen (MC) auf, die in einem matrixförmigen Speicherzellenfeld (1) angeordnet sind und zu adressierbaren Einheiten von Spaltenleitungen (BL) und Zeilenleitungen (WL) zusammengefaßt sind. Ein Decoder (10) zur Auswahl einer der Spaltenleitungen (BL) mittels eines Spaltenauswahlsignals (S11) weist einen Anschluß (12) für ein Eingangssignal (S12) auf zur Aktivierung des Spaltenauswahlsignals (S11). Ein Zeilenaktivierungssignal (S21) dient zur Aktivierung einer Zeilenzugriffs-Signalfolge (S22, S23). Der Anschluß (12) für das Eingangssignal (S12) des Decoders (10) ist mit einem Signal (S22) aus der Zeilenzugriffs-Signalfolge (S22, S23) verbunden, das anzeigt, daß der Zeilenzugriff abgeschlossen ist. Durch aufeinanderfolgende Signale im Prozeß des Speicherzugriffs wird verhindert, daß der Spaltenzugriff vor dem Ende des Zeilenzugriffs stattfindet. Der Speicherzugriff wird in selbstjustierender Weise gesteuert.

## Beschreibung

Die vorliegende Erfindung betrifft eine Schaltungsanordnung für einen integrierten Halbleiterspeicher mit einem Speicherzellenfeld mit Speicherzellen, die zu Einheiten von Spaltenund Zeilenleitungen zusammengefaßt sind, bei dem ein Zugriff auf eine der Spaltenleitungen erfolgt.

Integrierte Halbleiterspeicher weisen Speicherzellen auf, die häufig in einem Speicherzellenfeld, beispielsweise in einem matrixförmigen Speicherzellenfeld, angeordnet sind. Die Speicherzellen sind dabei meist zu adressierbaren Einheiten von Spaltenleitungen und Zeilenleitungen zusammengefaßt. Diese können beispielsweise Bitleitungen beziehungsweise Wortleitungen sein, in deren Kreuzungspunkten die Speicherzellen angeordnet sind.

Bei einem Lese- oder Schreibzugriff auf eine der Speicherzellen werden im allgemeinen die betreffende Zeilenleitung und Spaltenleitung über einen Decoder ausgewählt. Nach der Auswahl der betreffenden Zeilenleitung liegen an den entsprechenden Spaltenleitungen Datensignale der Speicherzellen entlang der Zeilenleitung an. Diese werden in einem benachbarten sogenannten Leseverstärkerstreifen des Speicherzellenfeldes verstärkt. Nach Auswahl der betreffenden Spaltenleitung wird das Datensignal der adressierten Speicherzelle freigeschaltet.

Um bestmögliche Zugriffszeiten beim Schreiben und Lesen eines integrierten Speichers zu erreichen, ist es erforderlich, daß die Signalpfade für die Auswahl der Zeilenleitungen und der Spaltenleitungen im Interesse einer kurzen Signallaufzeit möglichst kurz dimensioniert sind. Die Auswahl einer Zeilenleitung bzw. Wortleitung benötigt im allgemeinen mehr Zeit als die Auswahl einer Spaltenleitung bzw. Bitleitung. Hinsichtlich der Zugriffssteuerung muß die Zeilenleitung jedoch vor dem Zugriff auf die Spaltenleitung bereits aktiviert sein, um Signalstörungen beim Schreib- oder Lesevorgang möglichst zu vermeiden. Es ergibt sich die Anforderung, daß von der Spaltenseite her nicht schneller auf die Speicherzelle zugegriffen wird als von der Zeilenseite her.

Ist der Zeitpunkt für den Speicherzellenzugriff von externen Zugriffskommandos bestimmt, ist es bislang üblich, daß der Startzeitpunkt für die Spaltendecodierung gegenüber dem Startzeitpunkt für die Zeilendecodierung entsprechend den obigen Anforderungen zeitlich verzögert ist. Die Einhaltung dieser zeitlichen Verzögerung wird in standardüblichen Spezifikationen extern von einem Memory Controller garantiert. Bei schnellen Halbleiterspeichern (RLDRAM, FCRAM, etc.) ist die Spezifikation von extern anliegenden Befehlen dahingehend verändert, daß die Zeilen- und Spaltenadressen vom Controller gleichzeitig übergeben werden. In diesem Fall muß die zeitliche Steuerung von Spalten- und Zeilenzugriff intern kontrolliert werden, beispielsweise über eine Verzögerungsschaltung, die die Differenz zwischen der Spaltenzugriffszeit und der Zeilenzugriffszeit modelliert.

Eine derartige Verzögerungsschaltung weist beispielsweise eine Inverterkette oder allgemein aus Logikgattern aufgebaute Verzögerungsstufen auf. Durch eine derart realisierte Modellierung von Laufzeiten verringert sich jedoch im allgemeinen die Robustheit der integrierten Schaltung. Derartige Verzögerungsglieder sind vergleichsweise empfindlich bezüglich Prozeß-, Temperatur- und Spannungsschwankungen. Die Folge davon können variable und/oder nicht genau justierbare Verzögerungszeiten der Verzögerungsschaltung sein. Dadurch kann bei einem Speicherzugriff die Funktionsfähigkeit des Halbleiterspeichers beeinträchtigt sein.

Die Aufgabe der vorliegenden Erfindung ist es, eine Schaltungsanordnung für einen beschriebenen integrierten Halbleiterspeicher zur Durchführung eines Zugriffs auf eine der Spaltenleitungen anzugeben, die auf mehrere Arten von Halbleiterspeichern anwendbar ist und bei der die Funktionsfähigkeit der Schaltung möglichst unabhängig von äußeren Einflüssen gewährleistet ist.

Die Aufgabe wird gelöst durch die Merkmale des Patentanspruchs 1. Vorteilhafte Aus- und Weiterbildungen sind Gegenstand abhängiger Ansprüche.

Die Schaltungsanordnung für den integrierten Halbleiterspeicher weist Speicherzellen auf, die in einem Speicherzellenfeld angeordnet sind und die zu adressierbaren Einheiten von Spaltenleitungen und Zeilenleitungen zusammengefaßt sind. Die Schaltungsanordnung weist ferner einen Decoder zur Auswahl einer der Spaltenleitungen auf, der mit einer Spaltenauswahlleitung verbunden ist zur Übertragung eines Spaltenauswahlsignals. Der Decoder weist ferner einen Anschluß auf für ein Eingangssignal zur Aktivierung des Spaltenauswahlsignals. Die Schaltungsanordnung weist weiterhin einen Anschluß für ein Zeilenaktivierungssignal auf, das zur Aktivierung einer Zeilenzugriffs-Signalfolge dient, beispielsweise mit Hilfe eines entsprechenden Wortleitungsdecoders. Der Anschluß für das Eingangssignal des Spaltendecoders ist mit einem Anschluß für wenigstens ein Signal aus der Zeilenzugriffs-Signalfolge verbunden, das mit seinem Zustand anzeigt, daß der Zeilenzugriff abgeschlossen ist. Das Spaltenauswahlsignal wird also nicht aktiviert und damit die betreffende Spaltenleitung ausgewählt, bevor der Zugriff auf die zugehörige Zeilenleitung abgeschlossen ist. Das bedeutet, im Prozeß des Speicherzugriffs werden die aufeinanderfolgenden Prozeßschritte der Zeilendecodierung und Spaltendecodierung durch aufeinander folgende Auswahlsignale gesteuert. Der Prozeß des Speicherzugriffs erhält somit eine selbstjustierende Funktionsweise.

Bei einem derartigen Speicherzugriff kann somit der Einfluß der Technologie auf die Signallaufzeit selbststeuernd berücksichtigt werden. Ist die Speicherzugriffssteuerung beispielsweise taktgesteuert, sind die beschriebenen aufeinanderfolgenden Prozeßschritte des Speicherzugriffs unabhängig von der Taktfrequenz. Es entfällt die Modellierung der Signallaufzeiten durch Verzögerungsglieder, wodurch die Anfälligkeit gegenüber Prozeß-, Temperatur- oder Spannungsschwankungen vermieden wird.

In einer Weiterbildung der Erfindung weist die Schaltungsanordnung einen Leseverstärker auf, der einer der Speicherzellen einer ausgewählten Zeilenleitung zugeordnet ist, mit einem Anschluß für ein Aktivierungssignal. Das Aktivierungssignal ist Bestandteil der Zeilenzugriffs-Signalfolge. Im Zuge des Zeilenzugriffs wird der betreffende Leseverstärker aktiviert und damit der Zeilenzugriff beendet. Das Aktivierungssignal des Leseverstärkers ist somit in vorteilhafter Weise dazu geeignet, das Spaltenauswahlsignal zu aktivieren.

Weiterhin ist es möglich, daß der Anschluß für das Eingangssignal des Decoders zur Aktivierung des Spaltenauswahlsignals mit einem aus dem Aktivierungssignal des Leseverstärkers abgeleiteten Signal verbunden ist.

In einer Ausgestaltung der Erfindung weist die Schaltungsanordnung ein Speicherelement auf mit einem Setzeingang, einem Rücksetzeingang und einem Ausgang. An dem Setzeingang liegt beispielsweise ein Signal an, das den Spaltenzugriff freischaltet. Die Schaltungsanordnung weist außerdem ein logisches Gatter auf, das mit dem Ausgang des Speicherelements und mit dem Anschluß für das Signal aus der Zeilenzugriffs-Signalfolge verbunden ist. Die Zugriffssignale für den Spaltenzugriff und den Zeilenzugriff sind somit miteinander verknüpft. Ein Ausgang des logischen Gatters ist mit dem Anschluß für das Eingangssignal des Decoders verbunden.

Die Erfindung ist insbesondere vorteilhaft einsetzbar bei schnellen Halbleiterspeichern wie beispielsweise RLDRAM oder FCRAM, da durch die Selbstjustierung schnellstmögliche Laufzeiten bei hoher Funktionssicherheit ermöglicht werden.

Die Erfindung wird im folgenden anhand der in der Zeichnung dargestellten Figuren näher erläutert. Es zeigen
- Figur 1: ein matrixförmiges Speicherzellenfeld eines integrierten Halbleiterspeichers,
- Figur 2: eine Ausführungsform einer erfindungsgemäßen Schaltungsanordnung für einen Halbleiterspeicher,
- Figur 3: ein zeitliches Ablaufdiagramm gemäß der Schaltungsanordnung nach Figur 2

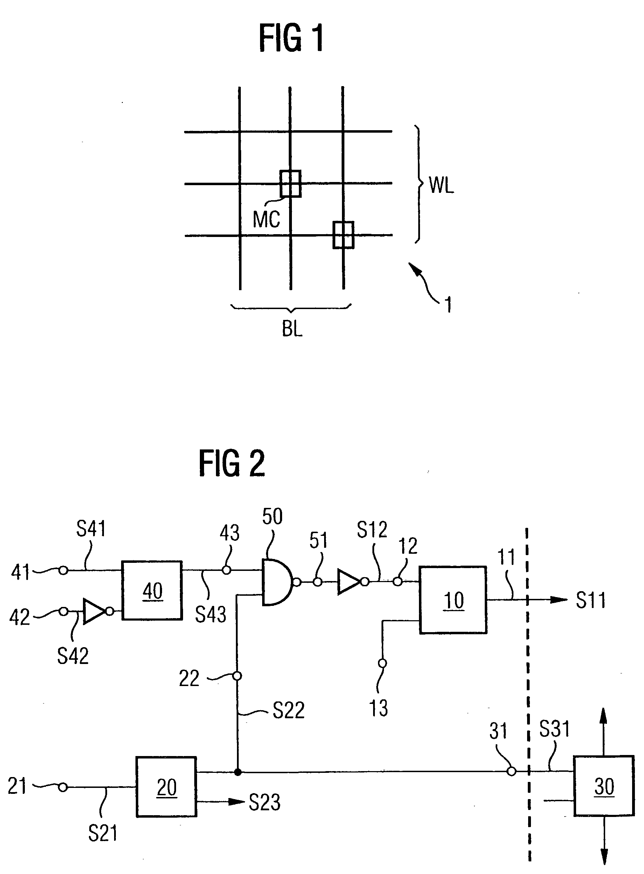

Figur 1 ist ein matrixförmig organisiertes Speicherzellenfeld 1 beispielsweise eines DRAM zu entnehmen, das reguläre Wortleitungen WL und Bitleitungen BL aufweist, in deren Kreuzungspunkten Speicherzellen MC angeordnet sind. Die Speicherzellen MC des gezeigten Speichers beinhalten jeweils einen Auswahltransistor und einen Speicherkondensator. Dabei sind Steuereingänge der Auswahltransistoren mit einer der Wortleitungen WL verbunden, während ein Hauptstrompfad der Auswahltransistoren zwischen dem Speicherkondensator der jeweiligen Speicherzelle MC und einer der Bitleitungen BL angeordnet ist.

Figur 2 zeigt eine Ausführungsform einer erfindungsgemäßen Schaltungsanordnung für einen integrierten Halbleiterspeicher. Die Schaltungsanordnung weist einen Decoder 10 auf, zur Auswahl einer der Spaltenleitungen BL, der mit einer Spaltenauswahlleitung 11 verbunden ist zur Übertragung eines Spaltenauswahlsignals S11. Der Decoder 10 weist ferner einen Anschluß 12 auf für ein Eingangssignal S12 zur Aktivierung des Spaltenauswahlsignals S11. An einem Anschluß 21 liegt ein Zeilenaktivierungssignal S21 an zur Aktivierung einer Zeilenzugriffs-Signalfolge. Diese wird mit Hilfe eines Wortleitungsdecoders 20 erzeugt und umfaßt die Signale S22 sowie S23. Das Signal S22 dient hier als Aktivierungssignal S31 für den Leseverstärker 30 an dessen Eingang 31. Das Signal S23 dient beispielsweise zur Aktivierung einer Wortleitung WL.

Die Schaltungsanordnung umfaßt weiterhin ein Speicherelement 40 mit einem Setzeingang 41, einem Rücksetzeingang 42 und einem Ausgang 43. Der Ausgang 43 des Speicherelements 40 ist mit dem logischen Gatter 50 verbunden, ebenso wie der Anschluß 22 für das Signal S22. Der Ausgang 51 des logischen Gatters 50 ist über einen Inverter mit dem Anschluß 12 für das Eingangssignal S12 des Decoders 10 verbunden. Ein weiterer Eingang 13 des Decoders 10 dient zur Eingabe einer vordecodierten Spaltenadresse. Das Signal S41 ist beispielsweise ein Spaltenaktivierungssignal zur Freigabe des Spaltenzugriffs. Das Signal S42 ist beispielsweise ein Aktivierungssignal, das eine Speicherbank aktiviert, in der sich die betreffende Spaltenleitung befindet.

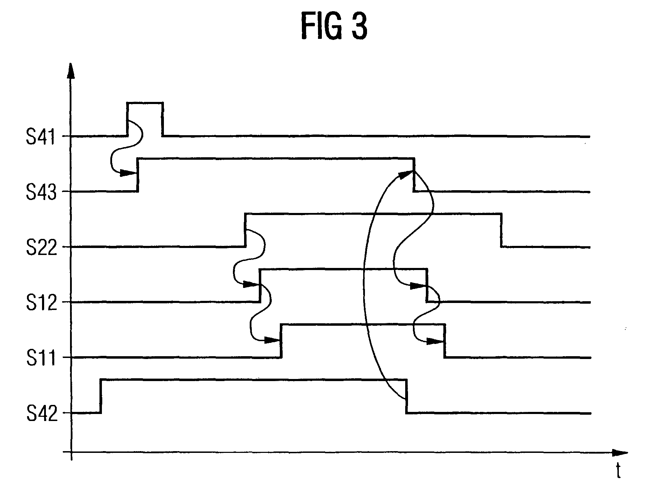

In Figur 3 ist ein zeitliches Ablaufdiagramm gemäß der Schaltungsanordnung nach Figur 2 dargestellt. Durch das aktive Spaltenaktivierungssignal S41 wird der Ausgang 43 des Speicherelements 40 mit dem Signal S43 gesetzt. Durch die steigende Flanke des Signals S22 wird über den Decoder 10 das Spaltenauswahlsignal S11 der adressierten Spaltenleitung gesetzt. Das Rücksetzen erfolgt mit der fallenden Flanke des Signals S42. Die fallende Flanke des Signals S42 ist dabei derart terminiert, daß das Spaltenauswahlsignal S11 inaktiv wird, bevor die betreffende Wortleitung deaktiviert wird.

## Patentansprüche

1. Schaltungsanordnung für einen integrierten Halbleiterspeicher
- mit Speicherzellen (MC), die in einem Speicherzellenfeld (1) angeordnet sind und zu adressierbaren Einheiten von Spaltenleitungen (BL) und Zeilenleitungen (WL) zusammengefaßt sind,
- mit einem Decoder (10) zur Auswahl einer der Spaltenleitungen (BL), der mit einer Spaltenauswahlleitung (11) verbunden ist zur Übertragung eines Spaltenauswahlsignals (S11), und der einen Anschluß (12) für ein Eingangssignal (S12) aufweist zur Aktivierung des Spaltenauswahlsignals (S11),
- mit einem Anschluß (21) für ein Zeilenaktivierungssignal (S21) zur Aktivierung einer Zeilenzugriffs-Signalfolge (S22, S23),
- bei der der Anschluß (12) für das Eingangssignal (S12) des Decoders (10) mit einem Anschluß (22) für wenigstens ein Signal (S22) aus der Zeilenzugriffs-Signalfolge (S22, S23) verbunden ist, das mit seinem Zustand anzeigt, daß der Zeilenzugriff abgeschlossen ist.

2. Schaltungsanordnung nach Anspruch 1,
**dadurch gekennzeichnet**, daß
- die Schaltungsanordnung einen Leseverstärker (30) aufweist, der einer der Speicherzellen (MC) einer ausgewählten Zeilenleitung (WL) zugeordnet ist, mit einem Anschluß (31) für ein Aktivierungssignal (S31), und
- der Anschluß (31) für das Aktivierungssignal (S31) mit dem Anschluß (22) für das Signal (S22) aus der Zeilenzugriffs-Signalfolge (S22, S23) verbunden ist,

3. Schaltungsanordnung nach Anspruch 2,
**dadurch gekennzeichnet**, daß
der Anschluß (12) für das Eingangssignal (S12) des Decoders (10) mit einem Anschluß für ein aus dem Aktivierungssignal (S31) des Leseverstärkers (30) abgeleitetes Signal verbunden ist.

4. Schaltungsanordnung nach einem der vorhergehenden Ansprüche,
**dadurch gekennzeichnet**, daß
- die Schaltungsanordnung ein Speicherelement (40) aufweist mit einem Setzeingang (41), einem Rücksetzeingang (42) und einem Ausgang (43),
- die Schaltungsanordnung ein logisches Gatter (50) aufweist,
- das logische Gatter (50) mit dem Ausgang (43) des Speicherelements (40) und mit dem Anschluß (22) für das Signal (S22) aus der Zeilenzugriffs-Signalfolge (S22, S23) verbunden ist und
- ein Ausgang (51) des logischen Gatters (50) mit dem Anschluß (12) für das Eingangssignal (S12) des Decoders (10) verbunden ist.
